# EUROPEAN PATENT APPLICATION

(11) **EP 4 760 275 A1**
(43) Date of publication of application: **17.06.2026**
(21) Application number: 24219146.8
(22) Date of filing: 11.12.2024
(51) Int. Cl.: G01R 22/06

(54) **AN ELECTRICITY METER**

(71) Applicant: Aidon Oy, 40100 Jyväskylä (FI)
(72) Inventor: Sievänen, Aleksi, 40100 Jyväskylä (FI); Lohvansuu, Juha, 40100 Jyväskylä (FI)
(74) Representative: Berggren Oy

(57) **Abstract**

An electricity meter according to the invention comprises terminals (14A, 14B, 14C, 14D, 14E, 14F) for inlet and outlet power cables for each phase (L1, L2, L3) and terminals (15A, 15B) for neutral inlet and outlet cables. The electricity meter also comprises a voltage meter arrangement (16A, 16B, 16C), for each phase (L1, L2, L3) to measure voltage between the phase (L1, L2, L3) and neutral (N). Further, the electricity meter further comprises a switch (17A, 17B, 17C) in each phase between the terminal (14A, 14C, 14E) of the inlet cable and the terminal (14B, 14D, 14F) of the outlet cable. In addition, the electricity meter comprises second voltage meter arrangements (18A, 18B, 18C) between the phases (L1, L2, L3).

## Description

### Field of technology

The invention relates to electricity meters which are designed to meter power consumption of a house/real estate, and other possible information.

### Prior art

An electricity meter is used to measure power consumption of a house/real estate, and other possible information. The electricity meter is located in a metering board, wherein the power is delivered through cables from a power distribution network. In practice the electricity meter is connected to the cables from the power distribution network by using inlet cables and possible rails.

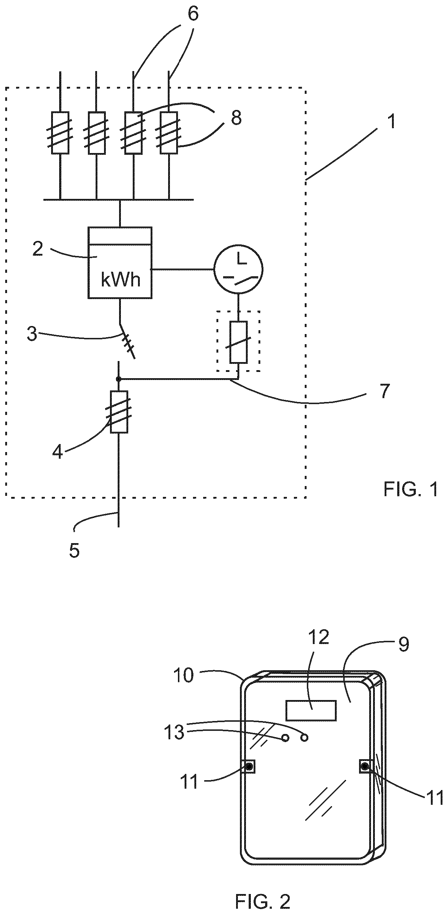

Figure 1 shows a schematic example of a metering board 1. Incoming distribution lines 5 (three phases), i.e. cables from a power distribution network, are connected to fuses/circuit breakers 4, which in turn are connected to a main switch 3, the main switch is connected to an electricity meter 2, which is also connected to supply lines 6 of a house or real estate. In practice, from the metering board the power is delivered to the house/real estate through outlet cables (and possible rails) and supply cables 6. The supply cables are power cables between the metering board and distribution board/s of the house/real estate.

The supply lines are provided with fuses/circuit breakers 8 as well. In order to secure that the electricity meter 2 works also if the main switch is switched off, the electricity meter has a parallel supply 7. In this way the electricity meter can record metering information during a fault situation where the main switch 4 is switched off.

Although, figure 1 does not show, it is usual to have neutral cables (i.e. cables/wires having neutral potential (ideally zero)). In this description, the neutral cable, (and a connection cable in the metering board) from the power distribution network side is called as an inlet neutral cable and the neutral cable (and a connection cable in the metering board) from the house side is called as an outlet neutral cable from the view of the electricity meter 2. The same can apply also to the power cables. Voltages between each phase and neutral are measured, and these voltages are used for energy calculation.

Figure 2 shows an example of an electricity meter 9, which is covered by a removeable cover 10. Here, in this example the removeable cover is illustrated as a transparent, but it can also be non-transparent. The removeable cover and the electricity meter comprise fasteners 11 which can be sealed. Usually, the electricity meter is also provided with a display 12 and a control button/s 13. So, the removable cover may comprise holes for at least to the control button/s. The electricity meter 9 comprises terminals (not illustrated in figure 2) for connecting inlet and outlet power cables and also terminals for connecting the inlet and outlet neutral cables. Further, the electricity meter comprises a switch in each phase between the terminal of the inlet cable and the terminal of the outlet cable. By disconnecting the switches power supply to the house can be stopped without discontinuing measuring and communication functions of the electricity meter.

### Short description

The object of the invention is to provide an electricity meter with versatile measurement capabilities. The object is achieved in a way described in the independent claim. Dependent claims illustrate different embodiments of the invention.

An electricity meter according to the invention comprises terminals for inlet and outlet power cables for each phase and terminals for neutral inlet and outlet cables. The electricity meter also comprises metering electronic, which comprises a voltage meter arrangement for each phase to measure voltage between the phase and neutral. Further, the electricity meter further comprises a switch in each phase between the terminal of the inlet cable and the terminal of the outlet cable,

In addition, the electricity meter comprises second voltage meter arrangements between the phases, which second voltage meter arrangements are arranged so that: one of them is between the terminal of the inlet cable of the first phase and the terminal of the outlet cable of the second phase, second one of them is between the terminal of the inlet cable of the second phase and the terminal of the outlet cable of the third phase, and third one of them is between the terminal of the inlet cable of third phase and the terminal of the outlet cable of the first phase.

### List of figures

In the following, the invention is described in more detail by reference to the enclosed drawings, where
- Figure 1: illustrates a schematic example of a metering board 1,
- Figure 2: illustrates an example of a known electricity meter,
- Figure 3: illustrates an example of a schematic circuit diagram according to the invention,
- Figure 4: illustrates an example of a detail of a circuit diagram according to the invention,
- Figure 5: illustrates an example of a terminal module according to the invention,
- Figure 6: illustrates an example of a circuit board module with the terminal module, and
- Figure 7: illustrates an example of a electricity meter according to the invention.

### Description of the invention

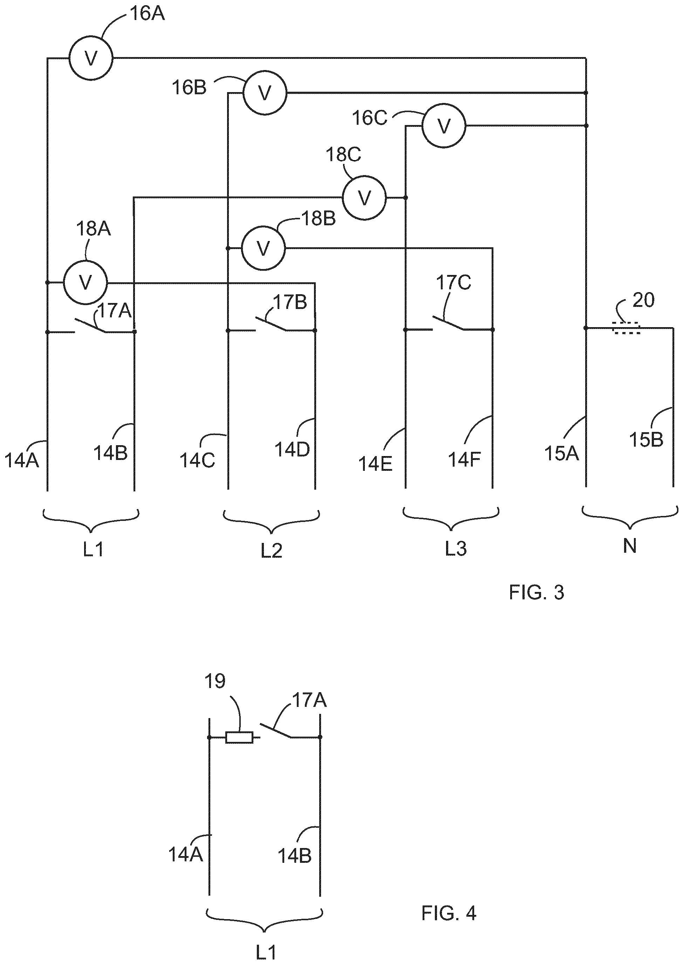

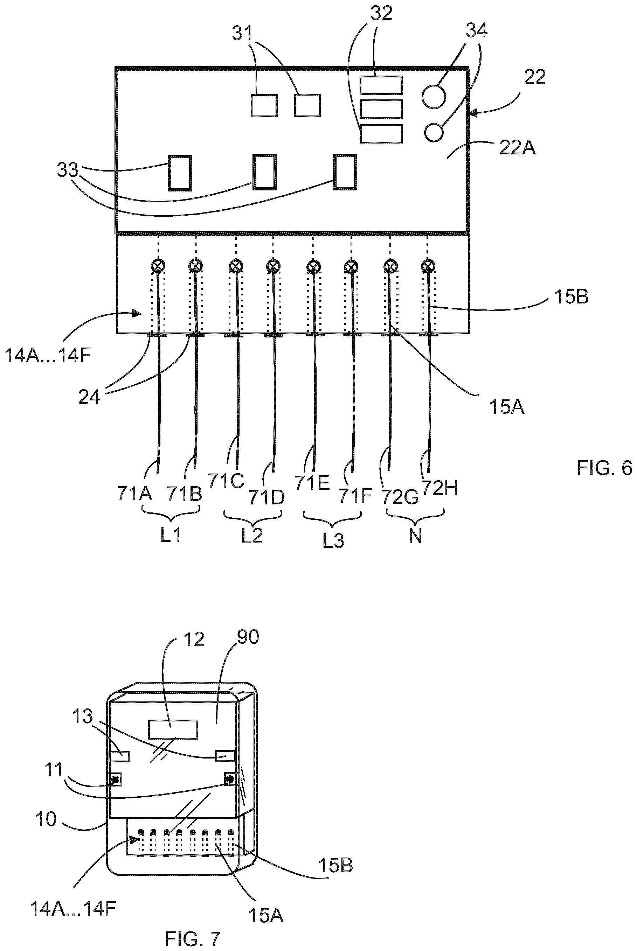

Figure 7 shows an example of an electricity meter 90 according to the invention with a removeable cover 10, and figure 3 an example of a schematic circuit diagram which illustrates metering arrangements in the electricity meter 90.

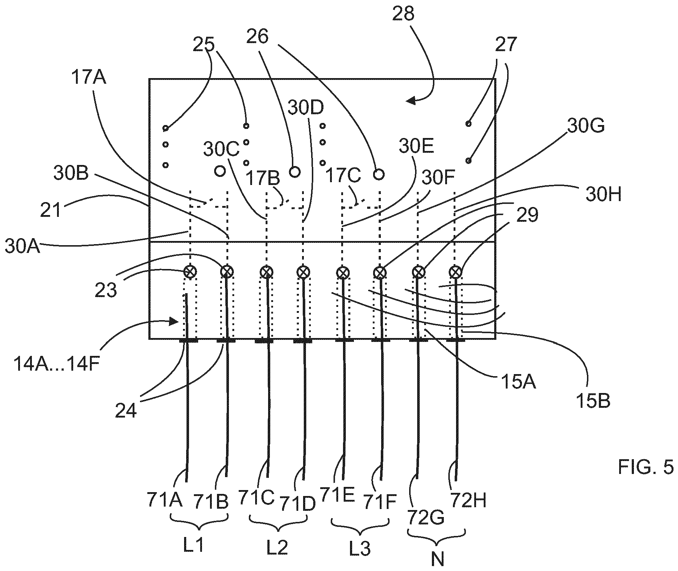

An electricity meter 90 according to the invention comprises terminals 14A, 14B, 14C, 14D, 14E, 14F for inlet and outlet power cables 71A, 71B, 71C, 71D, 71E 71F for each phase L1, L2, L3 and terminals 15A, 15B for neutral inlet and outlet cables 72G, 72H. The cables are illustrated in figures 5 and 6. The electricity meter also comprises metering electronic 22A, which comprises a voltage meter arrangement 16A, 16B, 16C, for each phase L1, L2, L3 to measure voltage between the phase L1, L2, L3 and neutral N. Further, the electricity meter further comprises a switch 17A, 17B, 17C in each phase between the terminal 14A, 14C, 14E of the inlet cable and the terminal 14B, 14D, 14F of the outlet cable,

In addition, the electricity meter 90 comprises second voltage meter arrangements 18A, 18B, 18C between the phases L1, L2, L3, which second voltage meter arrangements are arranged so that: one of them 18A is between the terminal 14A of the inlet cable of the first phase L1 and the terminal 14D of the outlet cable of the second phase L2, second one 18B of them is between the terminal 14C of the inlet cable of the second phase L2 and the terminal 14F of the outlet cable of the third phase L3, and third one 18C of them is between the terminal 14E of the inlet cable of third phase L3 and the terminal 14B of the outlet cable of the first phase L1. In the description the first phase is marked as L1, the second phase as L2 and the third phase as L3. However, other ways for marking are also possible.

As can be seen in figure 3 each voltage metering arrangement 16A, 16B, 16C is arranged to measure voltage of the phase with respect to neutral level. As known a power distribution system typically has three phases, and the power delivered by of the phases is measured by an electricity meter. Each phase has it's own wire/cable. More precisely the phase means a voltage phase in the wire/cable. The phases L1, L2, L3 are different from each other.

The second voltage meter arrangements 18A, 18B, 18C are arranged to measure voltages between the phases L1, L2, L3 when the switches 17A, 17B, 17C are connected. More precisely, the voltage meter arrangement 18A measures voltage between phase L1 (terminals 14A and 14B) and phase L2 (terminals 14C and 14B). The voltage meter arrangement 18B measures voltage between phase L2 (terminals 14C and 14D) and phase L3 (terminals 14E and 14F). The voltage meter arrangement 18C measures voltage between phase L3 (terminals 14E and 14F) and phase L1 (terminals 14Aand 14B). When the switches are connected the outlet cables 14B, 14D, 14F get voltage levels from the inlet cables A14, 14C, 14E.

The second voltage meter arrangements 18A, 18B, 18C are also arranged to measure voltages between the terminals 14B, 14D, 14F of the outlet cables of phases L1, L2, L3 and the terminals 14A, 14C, 14E of the inlet cables of the other phases when the switches are disconnected. More precisely, first one 18A of the second voltage meter arrangement is arranged measure voltage between the terminal 14D of the outlet cable of phase L2 and the terminal 14A of the inlet cable of phase L1 when switch 17B is disconnected. Second one 18B of the second voltage meter arrangement is arranged measure voltage between the terminal 14F of the outlet cable of phase L3 and the terminal 14C of the inlet cable of phase L2 when switch 17C is disconnected. Third one 18C of the second voltage meter arrangement is arranged measure voltage between the terminal 14B of the outlet cable of phase L1 and the terminal 14E of the inlet cable of phase L3 when switch 17A is disconnected.

In case of 3-phase power line with a neutral line usual/normal measured values of the second voltage meter arrangements 18A, 18B, 18C are 400 V when the switches are connected. Correspondingly usual/normal measured values of the voltage meter arrangements 16A, 16B, 16C are 230 V. These values are usual in power distribution in Europe. However, the measured values depend on the power line system, which is used. When the switches are disconnected the outlet cables 14B, 14D and 14F are not in connection to any voltage source, so their voltage levels should be neutral (or almost neutral) in normal condition. So, the measured values should correspond the measured values of the voltage meter arrangements. In this way, it is possible to detect differences between neutral levels of the distribution network side and the house side and possible faults in the house side.

Figure 4 shows a detail of another embodiment of the circuit according to the invention. It is possible that there is a minor resistor 19 in series with each switch 17A, 17C, 17E. See also figure 3. Figure 4 shows the resistor only with the switch 17A between the terminals 14A, 14B of phase L1, but similarly there is a resistor 19 with the switch 17B between the terminals 14C, 14D of phase L2, and with the switch 17C between the terminals 14E, 14F of phase L3. These minor resistors are used for measuring currents of the phases L1, L2, L3.

The circuit can also comprise a minor resistor 20 (illustrated as dashed lines in figure 20) between the terminals 15A, 15B for neutral inlet and outlet cables 72G, 72H for measuring possible current through neutral cables. The minor resistors 19, 20 are, for example, 200 mΩ.

Figure 5 shows an example of an embodiment how the terminals 14A...14F, 15A, 15B can be realized in the electricity meter. In this embodiment the electricity meter 1 comprises a terminal module 21 comprising said terminals 14A... 14F inside. the terminals are arranged so that the inlet and the outlet cables 71A, 71B, 71C, 71D, 71E 71F, 72G, 72H for each phase L1, L2, L3 and neutral are next to each other. Further, the electricity meter comprises a circuit board module 22, comprising the metering electronics. The circuit board module is attached to the terminal module 21 as illustrated in figure 6.

So, figure 5 shows an example of the terminal module 21. Figure 6 illustrates an example of the circuit board module 22 with the terminal module. The terminals 14A, 14B, 14C, 14D, 14E 14F, (the bodies of the terminals), for the inlet and outlet cables 71A, 71B, 71C, 71D, 71E 71F, and terminals 15A, 15B for neutral inlet and outlet cables 72G, 72H comprise the screws 23 to attach the cables, and openings 24 to insert the ends of the cables into the terminals.

So, the terminals are arranged so that the inlet and the outlet cables 71A, 71B, 71C, 71D, 71E 71F for each phase L1, L2, L3, and the neutral inlet and outlet cables 72G, 72H are next to each other. In this embodiment the inlet cables are referred to as 71A, 71C, and 71E. 72G and 72H refer to the inlet and outlet cables of neutral potential. The outlet cables are referred to as 71B, 71D, 71F. A pair of the inlet/outlet cables 71A and 71B belongs to the phase L1 of the three-phase power line. A pair of the inlet/outlet cables 71C and 71D belongs to the phase L2 of the three-phase power line. A pair of the inlet/outlet cables 71E and 71F belongs to the phase L3 of the three-phase power line.

Figure 5 shows also connections 25, 26, 27 in order to attach a circuit board module 22 on the terminal module 21. In this embodiment the front plate 28 of the terminal module 21 has holes 29 for the screws 23.

Figure 5 illustrates also that the terminal module 21 comprises the switches 17A, 17B, 17C for each phase L1, L2, L3 between the terminals 14A, 14B, 14C, 14D, 14E, 14F of the inlet cables and outlet cables. The terminals comprise extension connections 30A, 30B, 30C, 30D, 30E, 30F whereto the switches are connected. The extension connections (schematically illustrated) can also be used for the measurements of the phases and for connecting the terminals with the metering electronics.

Figure 6 shows a schematic example of the circuit board module 22 connected to the terminal module using said connections 25, 26, 27. The circuit board module 22 comprises one circuit board or two circuit boards connected to each other. The use of two circuit boards can be convenient so that one circuit board is for analog circuits and the other circuit is for digital circuits. Figure 6 shows schematically only one circuit board 22A having different components, like processors 31, memories 32, integrated circuits 33, capacitors 34 etc. So, the circuit board or circuit boards provides the metering electronics, in other words the circuit board/s comprises the illustrated voltage meter arrangements 16A, 16B, 16C and the second voltage meter arrangements 18A, 18B, 18C. The circuit board module, more precisely its circuit board/s makes calculations from the measurements.

Figure 3 shows schematically how the voltage meter arrangements 16A, 16B, 16C and the second voltage meter arrangements 18A, 18B, 18C can be arranged. In practice is also possible to make several different embodiments. For example, the voltage meter arrangements 16A, 16B, 16C and the second voltage meter arrangements 18A, 18B, 18C can be integrated together in order to have three integrated circuits 33. These integrated circuits are connected to the terminals as described above.

Figure 7 shows an example of an electricity meter 90 according to the invention with a removeable cover 10. The electricity meter is provided with a display 12, a control button/s 13, and fasteners 11 for the removable cover. The electricity meter comprises said terminals 14A, 14B, 14C, 14D, 14E, 14F for inlet and outlet power cables 71A, 71B, 71C, 71D, 71E 71F for each phase L1, L2, L3 and terminals 15A, 15B for neutral inlet and outlet cables 72G, 72H. The electricity meter also comprises metering electronic 22A, which comprises a voltage meter arrangement 16A, 16B, 16C, for each phase L1, L2, L3 to measure voltage between the phase L1, L2, L3 and neutral N, and also said second voltage meter arrangements 18A, 18B, 18C. Further, the electricity meter comprises said switches 17A, 17B, 17C. The switches are controllable switches, so they can be disconnected, for example when the supply lines to the house are desired to be in power-off condition. Naturally, the switches can also be connected. It is possible that the electricity meter has the above described terminal module 21 and the circuit board module 22.

In case the measurements detect a fault situation an alarm signal can be sent to a maintenance personnel through a communication device of the electricity meter 1. So, the electricity meter comprises the communication device like a wireless modem or a communication port module. Therefore, the maintenance personnel can react relatively quickly.

The invention provides an electricity meter with versatile measurement capabilities. The voltage meter arrangement 16A, 16B, 16C, for each phase L1, L2, L3 measures voltage between the phase L1, L2, L3 and neutral. When the switches are connected/closed (like almost any time), the second voltage meter arrangements 18A, 18B, 18C measure voltages between phases (400V). It is worth to mention that these voltage measurements can be used for energy calculation in a network, where neutral is missing, like in Norway.

When the switches are disconnected/open, the second meter arrangement measure voltages between the supply/household phase lines and the network lines/inlet cables coming to the electricity meter. Typically, household electricity lines go to neutral/near neutral/earth so these measurement results should be similar to the measurements from the voltage meter arrangements 16A, 16B, 16C. The comparison of these measurements can indicate whether the switches acted normally, and the house/real estate was disconnected from network, and whether no voltage detected (called as reverse voltage) in the supply lines. Further, at the same time comparison between neutral/earth in the house and the network neutral can be done. So, the measurements can indicate faults in the house.

As can be seen the invention can be realized in many ways. It is evident from the above that the invention is not limited to the embodiments described in this text but can be implemented in many other different embodiments within the scope of the independent claims.

## Claims

1. An electricity meter (90) comprising terminals (14A, 14B, 14C, 14D, 14E, 14F) for inlet and outlet power cables (71A, 71B, 71C, 71D, 71E 71F) for each phase (L1, L2, L3) and terminals (15A, 15B) for neutral inlet and outlet cables (72G, 72H), the electricity meter also comprising metering electronic (22A), which comprises a voltage meter arrangement (16A, 16B, 16C) for each phase (L1, L2, L3) to measure voltage between the phase (L1, L2, L3) and neutral (N), the electricity meter further comprises a switch (17A, 17B, 17C) in each phase between the terminal (14A, 14C, 14E) of the inlet cable and the terminal (14B, 14D, 14F) of the outlet cable,
, **characterised in that** the electricity meter (90) comprises second voltage meter arrangements (18A, 18B, 18C) between the phases (L1, L2, L3) which second voltage meter arrangements are arranged so that
one of them (18A) is between the terminal (14A) of the inlet cable of the first phase (L1) and the terminal (14D) of the outlet cable of the second phase (L2),
second one (18B) of them is between the terminal (14C) of the inlet cable of the second phase (L2) and the terminal (14F) of the outlet cable of the third phase (L3), and
third one (18C) of them is between the terminal (14E) of the inlet cable of third phase (L3) and the terminal (14B) of the outlet cable of the first phase (L1).

2. An electricity meter according to claim 1, **characterised in that** the second voltage meter arrangements (18A, 18B, 18C) are arranged to measure voltages between the phases (L1, L2, L3) when the switches (17A, 17B, 17C) are connected, and to measure voltages between the terminals (14B, 14D, 14F) of the outlet cables of phases and the terminals (14A, 14C, 14E) of the inlet cables of the other phases when the switches are disconnected.

3. An electricity meter according to claim 1 or 2, **characterised in that** it comprises a minor resistor (19) in series with each switch (17A, 17C, 17E).

4. An electricity meter according to claim 3, **characterised in that** it comprises a minor resistor (20) between the terminals (15A, 15B) for neutral inlet and outlet cables (72G, 72H).

5. An electricity meter according to claim 1, 2, 3 or 4, **characterised in that** the voltage meter arrangements (16A, 16B, 16C) and the second voltage meter arrangements (18A, 18B, 18C) are integrated together having three integrated circuits (33).

6. An electricity meter according to claim 1, 2, 3, 4 or 5, **characterised in that** the electricity meter (90) comprises a terminal module (21) comprising said terminals (14A, 14B, 14C, 14D, 14E, 14F, 15A, 15B) inside, the terminals being arranged so that the inlet and the outlet cables (71A, 71B, 71C, 71D, 71E 71F, 72G, 72H) for each phase (L1, L2, L3) and neutral (N) are next to each other, and the electricity meter further comprising a circuit board module (22), comprising the metering electronics, the circuit board module being attached to the terminal module (21).

7. An electricity meter according to claim 6, **characterised in that** the circuit board module (21) comprises one circuit board or two circuit boards connected to each other.
